# EUROPEAN PATENT SPECIFICATION

(11) **EP 4 430 642 B1**
(45) Date of publication and mention of the grant of the patent: **23.09.2026**
(21) Application number: 22826743.1
(22) Date of filing: 10.11.2022
(51) Int. Cl.: H01F 6/06, H01R 4/68, H02G 15/34

(54) **MODULAR HIGH CAPACITY CURRENT LEAD**
MODULARE STROMZUFÜHRUNG HOHER KAPAZITÄT
CONDUCTEUR DE COURANT MODULAIRE À HAUTE CAPACITÉ

(30) Priority: 12.11.2021 US 202163278850 P
(43) Date of publication of application: 18.09.2024
(73) Proprietor: MASSACHUSETTS INSTITUTE OF TECHNOLOGY, Cambridge, MA 02139 (US); Commonwealth Fusion Systems LLC, Cambridge, MA 02139 (US)
(72) Inventor: FRY, Vincent, Durham, North Carolina 27713 (US); ZHUKOVSKY, Alexander, Brighton, Massachusetts 02135 (US); MICHAEL, Philip, Cambridge, Massachusetts 02139 (US); IHLOFF, Ernest, Hampstead, New Hampshire 03841 (US); WOLF, Michael, 76646 Bruchsal,Baden-Württemberg (DE); BECK, William, Alton Bay, NH 03810 (US); ESTRADA, Jose, Lawrence, MA 01841 (US)
(74) Representative: Murgitroyd & Company
(86) International application number: PCT/US2022/049517
(87) International publication number: WO 2023/086453

(56) References cited:
- EP-B1- 0 482 840
- US-A- 6 034 324

## Description

### BACKGROUND

In electronics, a lead is an electrical connection made of metal used for various purposes, including transferring power. For resistive magnets, e.g. electromagnets made of coils of copper or copper compounds operable at room-temperature, the leads are fairly straightforward and are well known. However, current leads for superconducting magnets must convey high amounts of electrical power from a power source, such as an AC to DC rectifier, located at room temperature (e.g. about 293 K or 20 °C) to a superconducting wire or cable operated at cryogenic temperatures (e.g. 80 K, -193 °C, and below). High-temperature superconductors (HTS) may operate at temperatures near 77 K (-196 °C), produced by boiling, atmospheric liquid nitrogen, although high-field HTS magnets are invariably operated at even lower temperatures, such as 20 K (-253 °C), where their performances are substantially greater. Thus, the current lead must provide physical and electrical connection, but thermal separation, between the external power at room temperature and the magnetic coils at cryogenic temperature during both electrical charging of the magnet and during its operation.

US 6 034 324 A discloses a self-protected modular high temperature superconducting, HTS, down-lead that is capable of carrying large currents from a room temperature power source to a superconducting device operating at cryogenic temperatures. The down-lead incorporates a safety lead capable of carrying current and absorbing heat to protect the HTS material of the lead in the event of catastrophic failure of the HTS elements. The lead is in continuous contact with the HTS material and provides protection from interrupts and excess current. The down-lead is modular in design, and parts are easily replaced. Further, the down-lead is cooled through conduction in the middle stage, and gas cooled in the upper and lower stages by independent gas sources.

EP 0 482 840 B1 discloses a power lead for a cryostat having HTS conductors extending inward toward a pool of liquid cryogen in a cryostat in series with normal conductors extending from the HTS conductors to outside the cryostat. Tubular shrouds vented to atmosphere direct a flow of cryogen vapor along the HTS conductors to maintain them superconducting, and along normal conductors to remove Joule heat and heat leakage along the normal conductors.

### SUMMARY OF DISCLOSED EMBODIMENTS

Disclosed embodiments provide high capacity current leads that are modular, in the sense that they are assembled from component parts that provide electrical connections and vacuum sealing while permitting rapid, non-destructive disassembly and modular testing, maintenance, and replacement of components. In particular, indium wire is used to connect certain cryogenic components of the current lead. Indium wire electrical and thermal joints and vacuum seals are highly reliable, cryogenically friendly, and are fully repairable. By contrast, prior art methods of joining sections such as brazing are essentially permanent and irreparable. Disclosed embodiments thus reduce the cost and schedule risks that could happen if an assembly is improperly brazed, such as the existence of leaks in a vacuum seal. Moreover, disclosed embodiments may provide temperature regulation at the power supply terminal that can both heat and cool the leads relative to room temperature.

In accordance with a first aspect of the present disclosure, there is provided a current lead according to claim 1. Further details of embodiments of the current lead are provided in dependent claims 2-8.

According to another aspect, there is provided a system according to claim 9.

It is appreciated that the concepts, techniques, and structures disclosed herein may be embodied in other ways, and that the above summary of disclosed embodiments is thus meant to be illustrative rather than comprehensive or limiting. In particular, individual elements of different embodiments described herein may be combined to form other embodiments not specifically set forth above. Various elements, which are described in the context of a single embodiment, also may be provided in other embodiments separately, or in any suitable sub-combination. Moreover, other embodiments not specifically described herein also may be within the scope of the claims set forth below.

### DESCRIPTION OF THE SEVERAL VIEWS OF THE DRAWINGS

The manner and process of making and using the disclosed embodiments may be appreciated by reference to the drawings, in which like components are given like numbers, and:
FIG. 1 schematically shows a modular, high capacity current lead in accordance with the concepts, techniques, and structures disclosed herein;
FIG. 2 schematically shows the room-temperature terminal portion (RTTP) and another portion of the heat exchanger (HEX) body in accordance with an embodiment;
FIG. 3 schematically shows thermal operation of the RTTP;
FIG. 4 schematically shows the RTTP in an assembled configuration;
FIG. 5A shows the HEX in full, including its RTTP and main body;
FIG. 5B shows a cross-section of the HEX body along the line A-A, to more clearly illustrate the relationship between the coolant grooves and the conductor comprising the HEX body;
FIG. 5C shows the path taken by coolant gas through the parallel grooves;
FIG. 6A schematically shows how the HEX is mechanically coupled to a boiling chamber (BC) in accordance with an embodiment;
FIG. 6B shows the BC lid vacuum seal in more detail;
FIG. 6C shows the BC base vacuum seal in more detail;
FIG. 7 schematically shows modular assembly of the boiling chamber and the vacuum lid;
FIG. 8 schematically shows coupling of the HEX body to the boiling chamber;
FIG. 9A schematically shows how cryogenic coolant is introduced into the boiling chamber;
FIG. 9B schematically shows how a cryogenic coolant level may be measured;
FIG. 10A schematically shows how gaseous coolant (e.g. gaseous nitrogen) exits the boiling cavity;
FIG. 10B schematically shows how gaseous coolant exits the vacuum lid cavity;
FIG. 11 schematically shows an assembled heat exchanger and boiling chamber;
FIG. 12A schematically shows more detail of clamps near the vacuum lid and boiling chamber;
FIG. 12B schematically shows a configuration of the lower coolant level tube port;
FIG. 13 schematically shows a cutaway view of an assembled heat exchanger and boiling chamber with liquid coolant;
FIG. 14A schematically shows one of several electrical connectors ("petals") of a superconductor module in accordance with an embodiment;
FIG. 14B shows an enlargement of the upper copper portion and the connecting plate of a petal near a brazed end of the latter;
FIG. 15 shows a side view of a manner of assembling high-temperature superconductor (HTS) tapes into a petal;
FIG. 16A is a side view of a superconductor module having six petals;
FIG. 16B is a bottom perspective view of the superconductor module of FIG. 16A;
FIG. 17 schematically shows current flow through an assembled heat exchanger / boiling chamber / superconductor module in accordance with an embodiment;
FIG. 18A schematically shows a lower portion of a superconductor module having six petals;
FIG. 18B schematically shows the lower portion of the superconductor module of FIG. 18A, with an installed clamping fixture and superconducting cable;
FIG. 19 schematically shows an alternate embodiment of the concepts, techniques, and structures disclosed herein, in which the vacuum lid and the boiling chamber lid are brazed to the boiling chamber base;
FIG. 20A schematically shows a cross-section of a "jacketed former" superconductor module in accordance with an embodiment of the concepts, techniques, and structures disclosed herein;
FIG. 20B schematically shows a former in accordance with the embodiment of FIG. 20A; and
FIG. 20C schematically shows a jacket surrounding a former in accordance with the embodiment of FIGs. 20A and 20B.

### DETAILED DESCRIPTION OF EMBODIMENTS

As used herein, "critical temperature" of a material means a temperature at which the material undergoes a phase change from electrically conducting to electrically superconducting. Critical temperature can depend on non-material conditions, such as the presence of an external magnetic field, or internal electrical transport current. Where the critical temperature of a material is referred to herein, this term refers to whatever the critical temperature happens to be for that material under the given conditions.

"Room temperature" refers to an ambient environmental temperature comfortable for sustained human life and work. When not otherwise specified, "room temperature" is taken to be a temperature in the range 15 °C to 30 °C.

A "high-temperature superconductor" or "HTS" refers to a material that has a critical temperature above 30 K at zero self-field.

As described above, current leads for superconducting magnets convey high amounts of electrical power from a room temperature power source to a superconducting wire or cable that is operated at cryogenic temperatures. Thus, such a current lead provides physical and electrical connections between the power source and cryogenic components of a magnet, while thermally separating the cryogenic components from the room temperature power source.

There are two main problems with existing current lead designs, and especially those that supply high current. First, the section in a typical lead that contains HTS material is usually created as a single unit. This means that copper, steel, and HTS material are all joined together, usually by soldering and brazing, into one large object. Typically, HTS material in such a structure is provided as an HTS tape, which is a flat structure comprising HTS material in addition to conventional electrical conductors. In order to confirm that the HTS section can carry the desired current, there must be a facility large enough to cool the entire HTS section below the critical temperature of the warm end, and to pass through it all of the current plus whatever margin is needed in order to ensure the superconductor is not degraded in quality. This requires an extremely large facility, especially for HTS sections with high currents.

It is important to note that the shape of the HTS section is typically cylindrical due to the relationship between the critical current of the HTS and the magnetic fields produced when it transmits current. In short, HTS tapes have the highest critical current when magnetic field lines run parallel to the flat side of the superconductive tapes. By placing these flat tapes face-down on the outside diameter of a cylinder, one obtains magnetic field lines that are also circular and thus are parallel to the faces of the tapes, increasing their critical current which minimizes cost spent on HTS.

Second, current leads are formed from large assemblies (e.g., including both a resistive, and a superconducting HTS section) that are typically brazed together to make them structurally and electrically continuous, as well as vacuum tight. Vacuum brazing can join similar or dissimilar metals such as copper and stainless steel together, and creates a very strong structural and electrical bond if the braze process is successful. Brazing processes can sometimes produce an undesirable result of permanently bonding the two materials together, however, in which case the materials may have to be cut apart to try again, which is not always feasible. Additionally, brazing (similar to soldering) is imperfect at joining surfaces and it is usually prudent to do some non-destructive testing such as ultrasound to investigate the bond quality between two surfaces. Brazed interfaces that act as seals are desirably completely continuous or else the coolant within the current leads can be pulled into the surrounding vacuum space, degrading its thermally insulating properties. Inspection and repair are sometimes not physically possible, and thus brazing risks losing the entire assembly.

Another common joining method is electron beam welding which can fuse dissimilar metals together with high energy electrons. This process is highly specialized, requires significant testing, and only a few companies in the world have the capability and the size required for large current leads.

The physical structure of one embodiment is now described with reference to the Figures. This particular embodiment is explained in detail to concretely illustrate the general concepts, techniques, and structures disclosed herein, but it is appreciated that this disclosure may be embodied differently without departing from its teachings. Thus, the extended discussion of this particular embodiment should not be viewed as limiting.

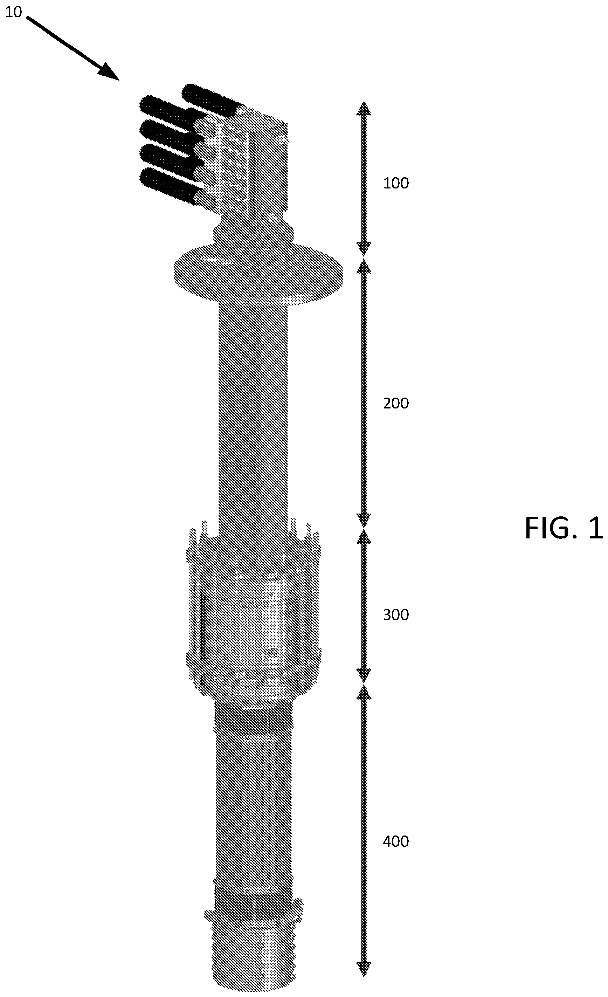

FIG. 1 schematically shows a modular, high capacity current lead 10 in accordance with the concepts, techniques, and structures disclosed herein. According to some embodiments, a "high capacity" cable may include a cable that conducts a current in excess of 1000 amperes (1 kA), or 10,000 amperes (10 kA), or more. The current lead 10 has a heat exchanger (HEX) having a room-temperature terminal portion (RTTP) 100 and a cryogenically-cooled body 200, a boiling chamber (BC) 300 for the cryogenic coolant, and a superconductor module 400 comprising a high-temperature superconductor (HTS). In various embodiments, the RTTP 100 may have a height of approximately 0.4 meters, the HEX body 200 may have a height of approximately 1 meter, the boiling chamber 300 may have a height of approximately 0.3 meters, and the superconductor module 400 may have a height of approximately 1 meter. It is appreciated that these measurements are merely illustrative, and they should not be viewed as limiting. These components are now described in more detail.

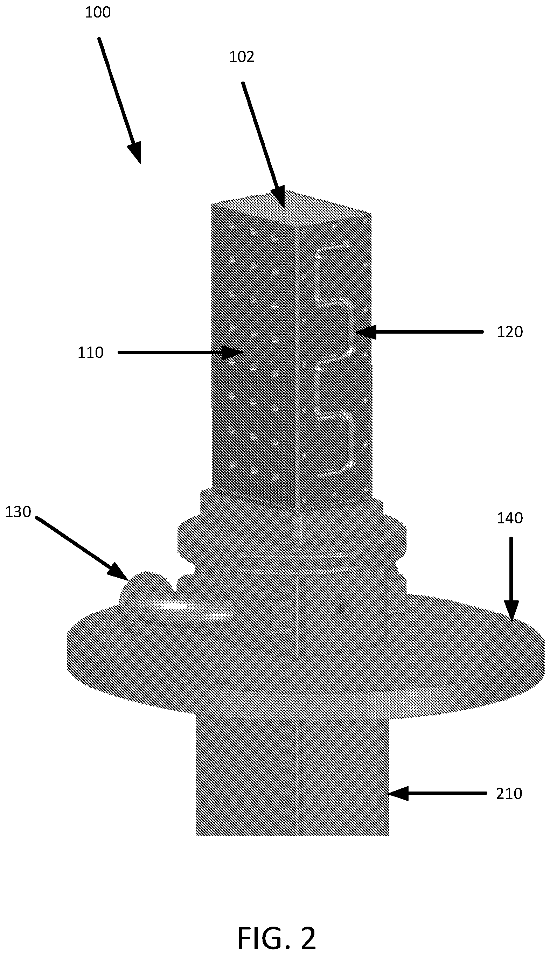

FIG. 2 schematically shows the RTTP 100 and a portion of the HEX body 200 in accordance with an embodiment. The RTTP 100 has an exposed conductor 102 that includes an electrical transfer surface 110 for electrically connecting the current lead to one or more room-temperature power supply lines. The RTTP 100 also includes a coolant channel 120 for cooling the exposed conductor 102 to thereby regulate its temperature, and in particular to prevent underheating (via condensation or freezing) and to prevent overheating (via resistive power loss). The room-temperature coolant may be thermally-regulated liquid water, or some other convenient coolant. The RTTP 100 also has one or more cryogenic coolant exhaust ports 130. And the RTTP 100 has a mounting surface 140 that allows mounting of the current lead 10 to a vacuum chamber cryostat. As the current lead below this mounting surface 140 is exposed to a vacuum, the HEX body 200 is clad in a vacuum shell, of which a portion 210 is shown.

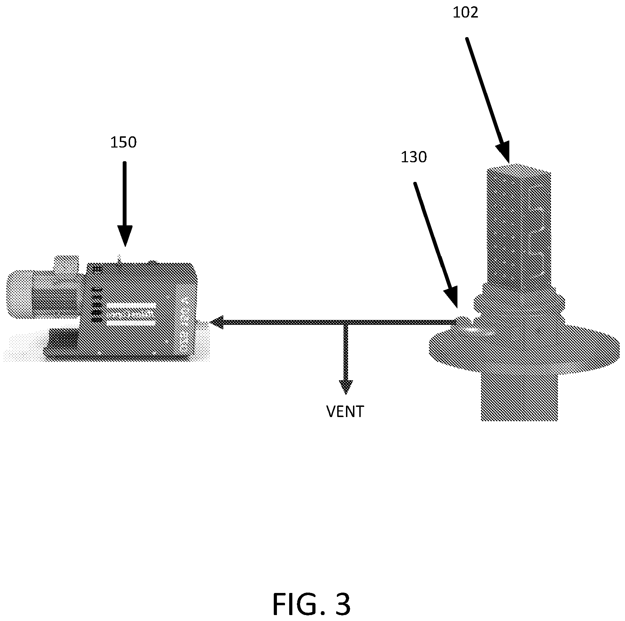

FIG. 3 schematically shows thermal operation of the RTTP 100. As noted above, the RTTP 100 includes one or more exhaust ports 130. As shown in FIG. 3, these exhaust ports 130 permit escape of cryogenic coolant that has been used to cool other components of the current lead. The cryogenic coolant illustratively is liquid nitrogen (LN2), but may be another coolant in different embodiments. Two coolant evacuation modes are shown. In the first mode, the coolant is vented directly to the surrounding environment (e.g. LN2 evacuating to the atmosphere at 1 atm pressure and its 77.3 K boiling point). In the second mode, the boiling coolant is pumped through a pressure-reducing pump 150 coupled to the one or more exhaust ports 130 (e.g. LN2 at about 150 Torr and 65 K). As discussed below, if the superconductor module 400 is too close to its critical temperature, reducing the pressure in the boiling chamber 300 reduces the LN2 temperature.

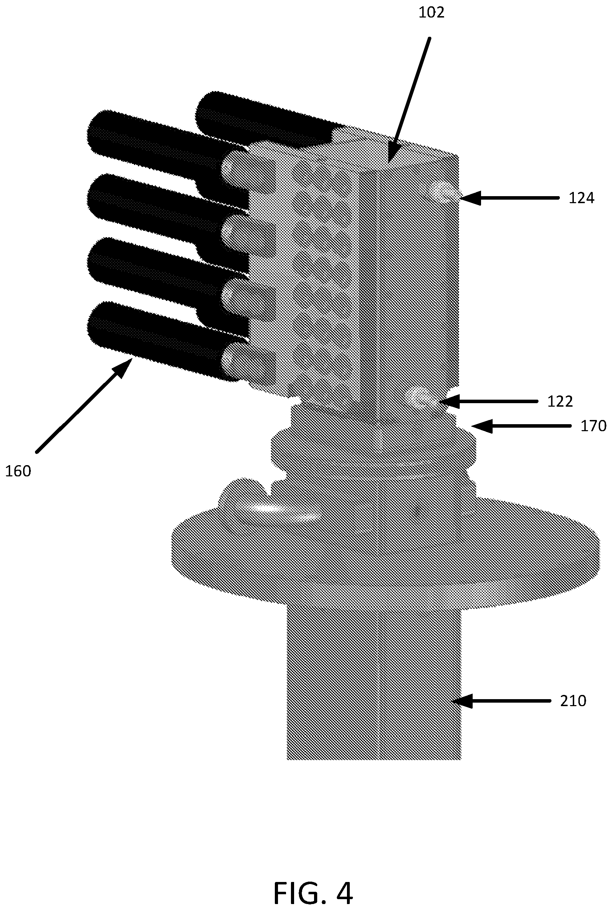

FIG. 4 schematically shows the RTTP 100 in an assembled configuration. A plate covers the coolant channel 120 through the exposed conductor 102. The plate has a coolant inlet 122 and a coolant outlet 124 coupled to the coolant channel 120. The electrical transfer surface 110 of the exposed conductor 102 is physically and electrically connected, via a plate, to one or more room-temperature power supply lines 160. These supply lines 160 are connected to an external power source, such as an AC to DC rectifier. The exposed conductor 102 is separated from the coolant passages in the HEX body 200 by an O-ring seal 170 or other suitable sealing mechanism.

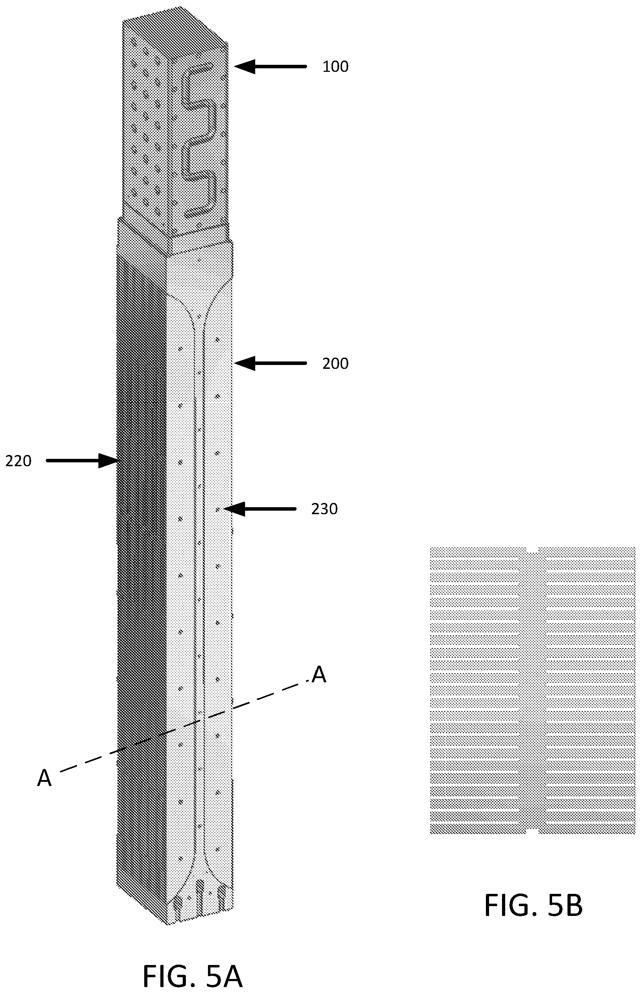

FIG. 5A shows the heat exchanger (HEX) in full, including its RTTP 100 and body 200. The HEX is made of a single, contiguous electrical conductor, such as copper. Thus, the HEX is electrically coupled from one end to the other. The vacuum shell 210 is not shown in FIG. 5A. The HEX body 200 includes several parallel coolant grooves 220.

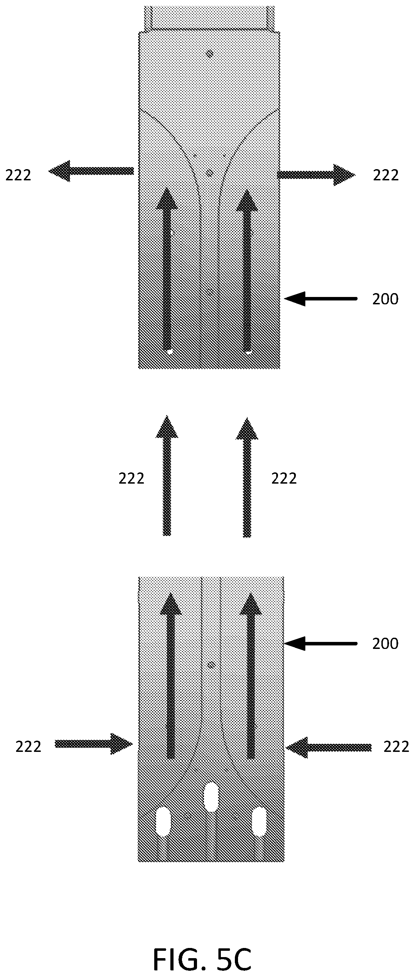

FIG. 5B shows a cross-section of the HEX body 200 along the line A-A, to more clearly illustrate the relationship between the coolant grooves 220 and the conductor comprising the HEX body. The coolant grooves 220 may be created using slitting saws or similar tools. The HEX body 200 also includes holes, of which hole 230 is one, to equalize coolant properties (such as pressure and temperature) between the coolant grooves 220 at different locations along the HEX body 200. FIG. 5C shows the path taken by coolant gas 222 (e.g. cryogenic nitrogen) through the parallel grooves 220, from the base to the top of the HEX body 200. The top of the HEX body 200 is its RTTP 100, while the base of the HEX body is thermally and electrically coupled to a boiling chamber, as now described.

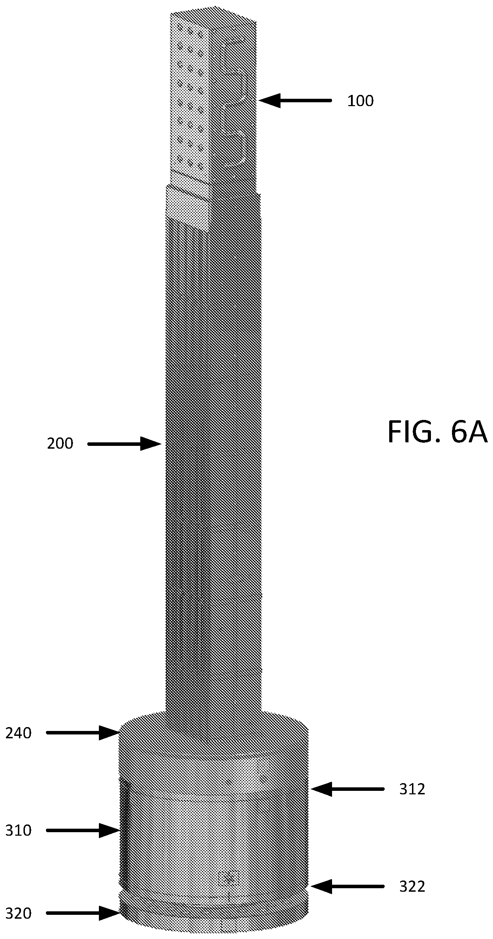

FIG. 6A schematically shows how the HEX 100, 200 is mechanically coupled to a boiling chamber in accordance with an embodiment. The boiling chamber (BC) comprises a BC lid 310 and a BC base 320. The BC lid 310 and BC base 320 may be made of copper, or other electrically conductive material such as brass. The HEX body 200 is coupled to the BC lid 310 via a vacuum lid 240. The vacuum lid 240 is sealed to the BC lid 310 via a BC lid vacuum seal 312 which separates the cryogenic coolant from the cryostat vacuum. In accordance with embodiments, the BC lid vacuum seal 312 comprises an indium electrical joint. Similarly, the BC lid 310 is sealed to the BC base 320 via a BC base vacuum seal 322 which separates the cryogenic coolant from the cryostat
vacuum. Additionally, the BC base vacuum seal 322 electrically couples the BC lid 310 to the BC base 320 and may comprise an indium electrical joint in accordance with embodiments.

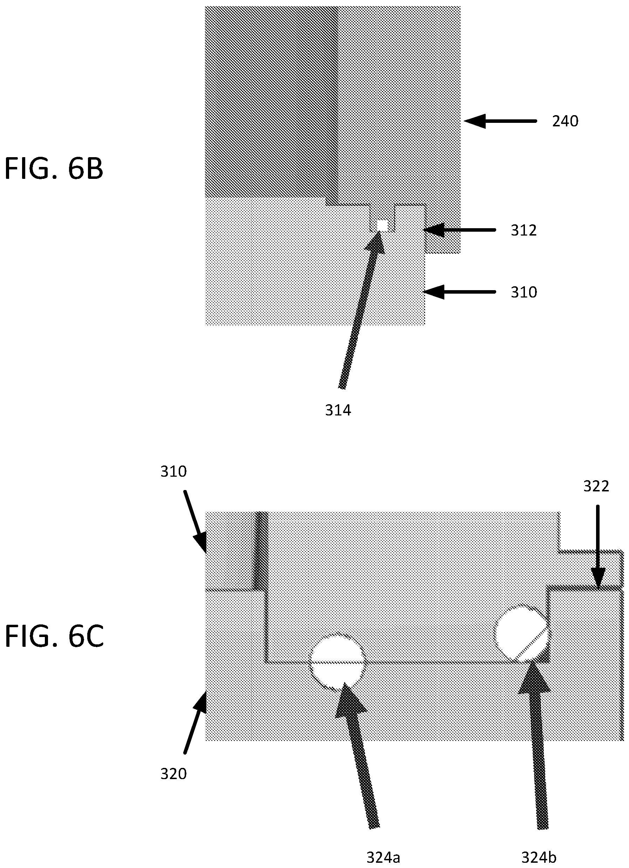

FIG. 6B shows the BC lid vacuum seal 312 in more detail. The BC lid vacuum seal 312 is formed between the vacuum lid 240 and the BC lid 310. In accordance with embodiments, the BC lid vacuum seal 312 includes an indium wire 314. The indium wire 314 may have a diameter of approximately 0.030 inches, although it should be understood that this dimension is merely illustrative and should not be viewed as limiting.

FIG. 6C shows the BC base vacuum seal 322 in more detail. The BC base vacuum seal 322 is formed between the BC lid 310 and the BC base 320. In accordance with embodiments, the BC base vacuum seal 322 may include indium wires 324a, 324b that provide an electrical joint. The indium wires 324a, 324b may have diameters of approximately 0.062 inches, although it should be understood that this dimension is merely illustrative and should not be viewed as limiting.

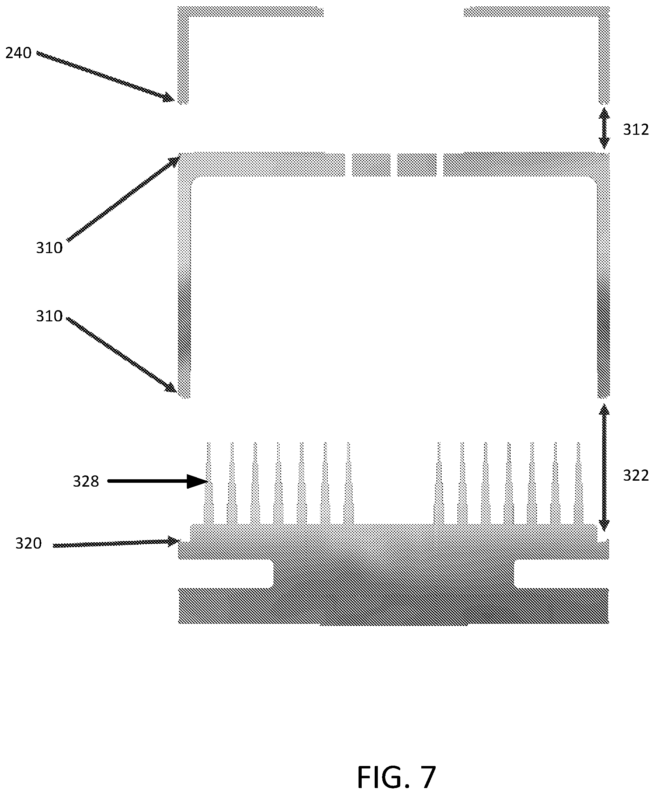

FIG. 7 schematically shows modular assembly of the boiling chamber and the vacuum lid. The vacuum lid 240 is sealed to the BC lid 310 via the BC lid vacuum seal 312, including use of an indium seal. The BC lid 310 is vacuum sealed and electrically coupled to the BC base 320 via the BC base vacuum seal 322, which also may include use of an indium seal. Because indium is a malleable metal, sealing the components to each other in this manner advantageously permits later non-destructive disassembly of the current lead for testing, maintenance, and repair, or for other foreseeable purposes. The BC base 320 includes one or more BC fins 328 to act as nucleation sites for boiling the liquid coolant.

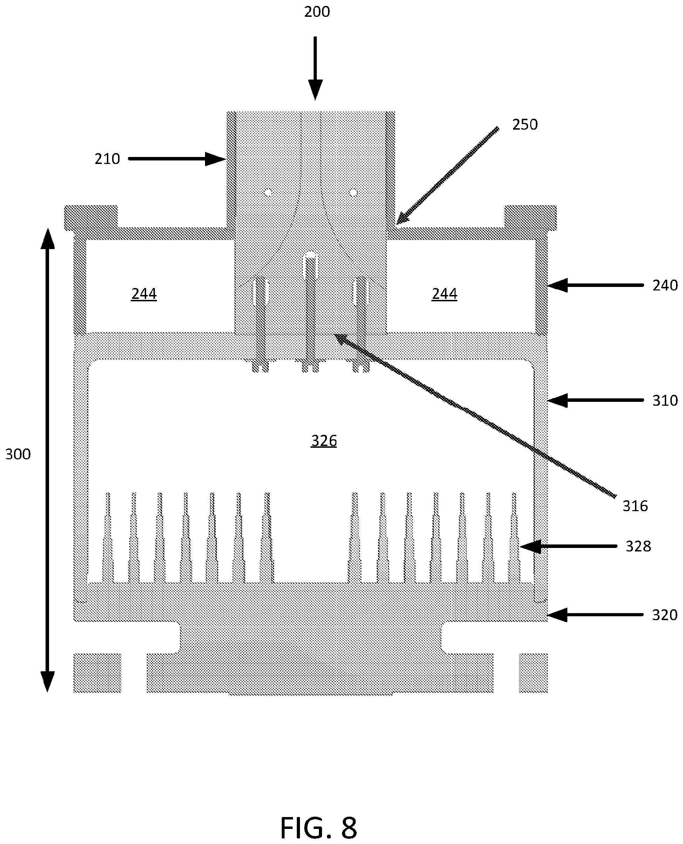

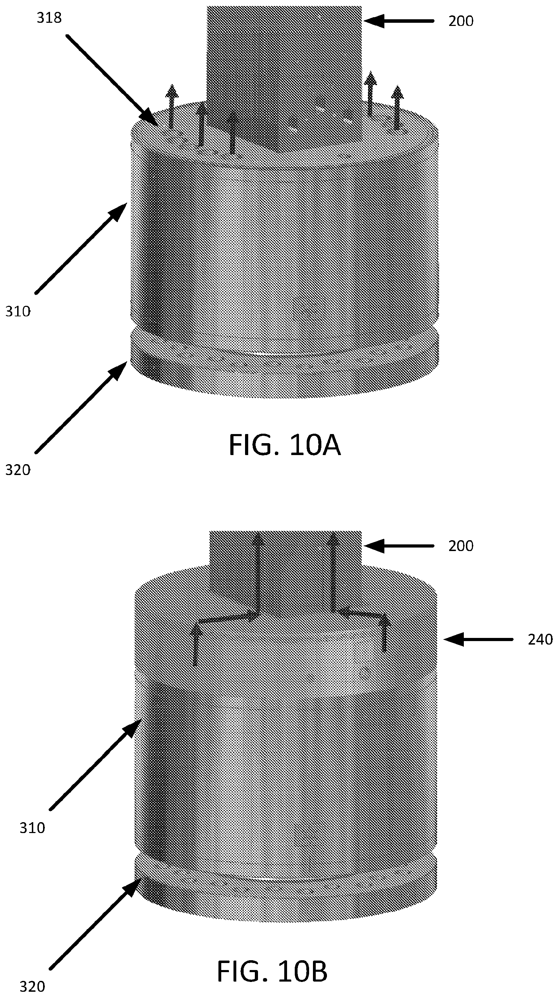

FIG. 8 schematically shows coupling of the HEX body 200 to the boiling chamber 300. The HEX body 200 is mechanically coupled to the assembled boiling chamber 300 via one or more internal BC lid clamps, which may be implemented using bolts. The HEX body 200 is electrically coupled to the boiling chamber 300 along the respective mating faces 316 using indium wire. Again, the use of indium as an electrical joint permits later disassembly of the current lead, and in particular separation of the HEX body 200 from the boiling chamber 300 with a minimum of mechanical stress. Also shown is the vacuum lid 240, which is sealed to the vacuum shell 210 at mechanical joints such as joint 250, which may be e.g. a weld or braze. Notably, after the BC lid 310 is joined to the BC base 320, a BC cavity 326 is formed in which a gaseous coolant (e.g. gaseous nitrogen, GN2) is retained. Exhaust gases formed near the nucleation fins 328 travel through the BC cavity 326 into a vacuum lid cavity 244, as described in more detail in connection with FIGs. 10A and 10B, and thence upward along the HEX body 200 as described in connection with FIG. 5C.

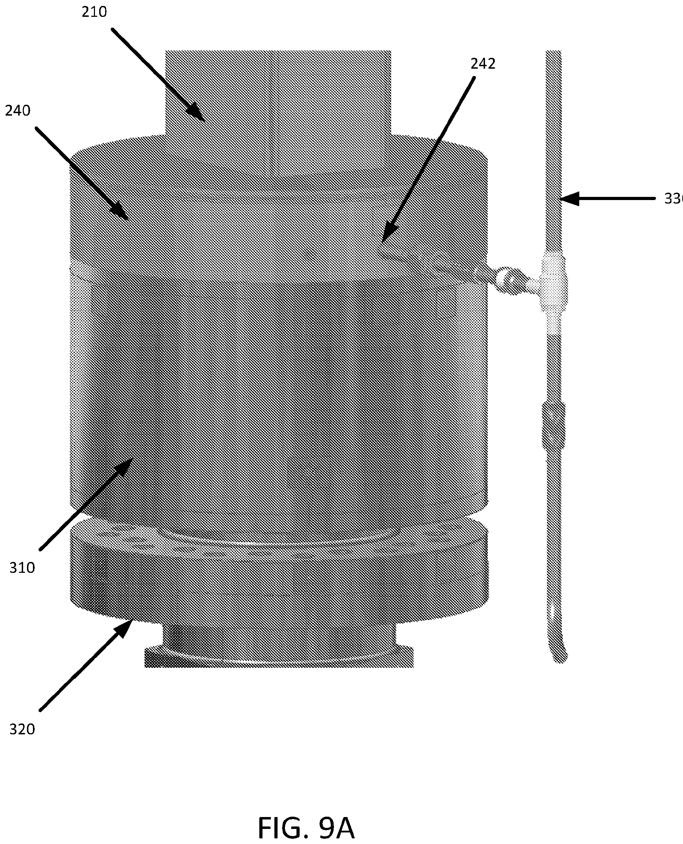

FIG. 9A schematically shows how cryogenic coolant is introduced into the boiling chamber. Shown are a lower portion of the vacuum shell 210 that clads the heat exchanger, the vacuum lid 240 for the boiling chamber (BC), the BC lid 310, and the BC base 320. Also shown are a cryogenic coolant supply line 330, and a vacuum lid coolant intake port 242. The vacuum lid 240 may be considered as part of the boiling chamber, and may include one or more coolant intake ports 242. Cryogenic coolant, such as liquid nitrogen (LN2), flows through the coolant supply line 330 and enters the vacuum lid using the coolant intake port 242. From there, it passes into the BC cavity 326 (not shown in this Figure) to be boiled.

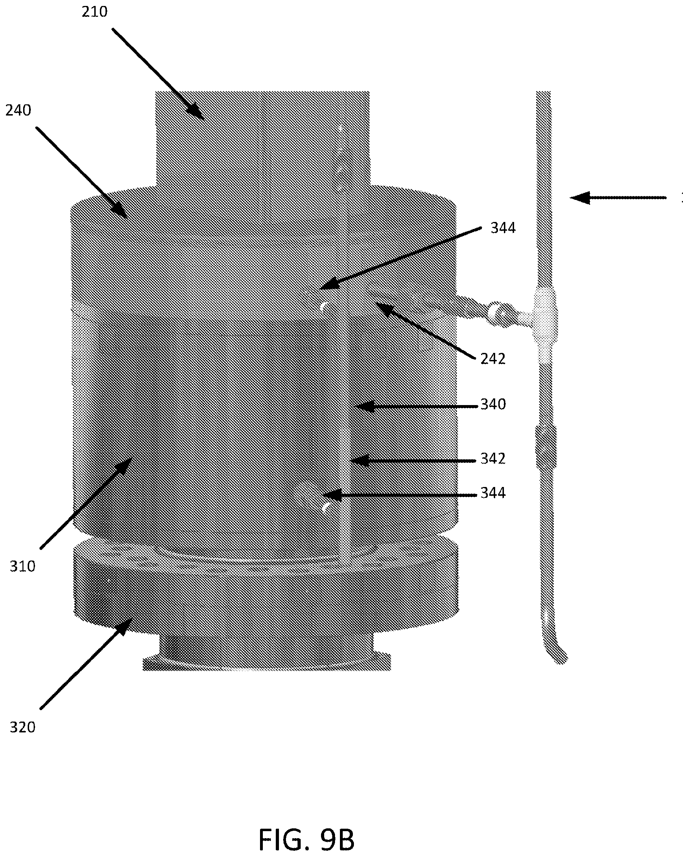

FIG. 9B schematically shows how a cryogenic coolant level may be measured. The structures described in connection with FIG. 9A are coupled via coolant level tube ports 344 to a coolant level tube 340 that is external to the boiling chamber 300. The liquid coolant (e.g. LN2) fills this vertical coolant level tube 340 like a sight tube. A coolant level sensor 342 measures the coolant level. The coolant level sensor 342 for this embodiment is a capacitive sensor that sits inside the level tube 340, although other sensor types may be used.

FIG. 10A schematically shows how gaseous coolant (e.g. GN2) exits the boiling chamber. Shown are the BC lid 310 and the BC base 320, between which is formed the boiling cavity 326 (not shown). Also shown is a bottom portion of the heat exchanger (HEX) base 200. In the BC lid 310 are provided BC lid coolant exhaust holes, indicated by item 318. Once liquid coolant has been boiled in the boiling cavity 326, it escapes through these coolant exhaust holes into the vacuum lid cavity 244 as indicated (the vacuum lid 240 that forms the top of the cavity 244 is not shown in this Figure, but is shown in FIG. 10B).

FIG. 10B schematically shows how gaseous coolant exits the vacuum lid cavity. Gaseous coolant, having escaped from the boiling chamber as indicated in FIG. 10A, is forced under its own pressure into grooves in the heat exchanger (HEX) body 200. These grooves are shown in FIG. 5A and 5B. Not shown in FIG. 10B is the vacuum shell 210 that retains the gaseous coolant within these grooves.

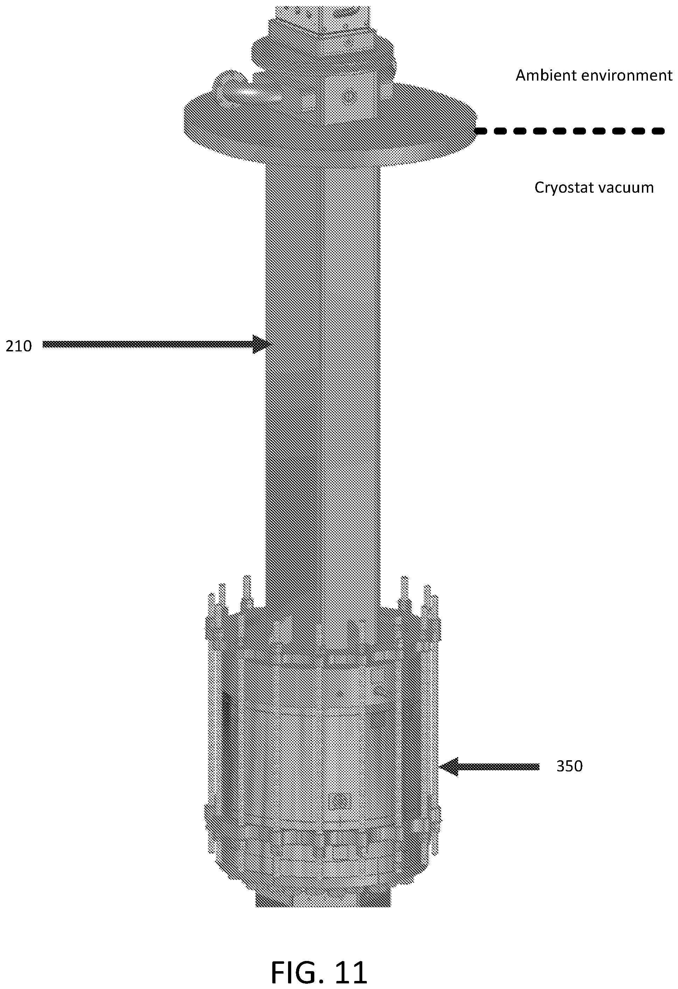

FIG. 11 schematically shows an assembled heat exchanger (HEX) and boiling chamber. The ambient environment and cryostat vacuum environments are shown for reference. Also shown is the vacuum shell 210, which is welded to the top of the vacuum lid 240, and surrounds the cryogenic portion of the HEX to keep coolant separated from the vacuum of the cryostat and from room temperature gas. Also shown are compression elements 350 (illustratively, threaded rods and clamps) that keep the indium seals between the vacuum lid 240, the BC lid 310, and the BC base 320 in constant compression.

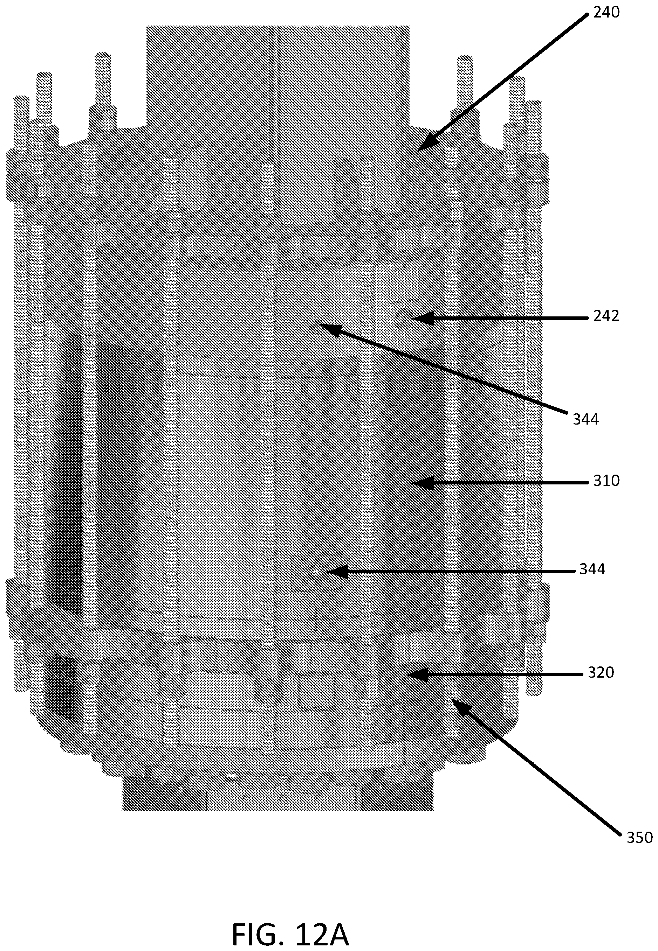

FIG. 12A schematically shows more detail of the clamps near the vacuum lid and boiling chamber. Shown are the vacuum lid 240, the vacuum lid coolant port 242, the BC lid 310, the BC base 320, the coolant level tube ports 344, and compression elements 350.

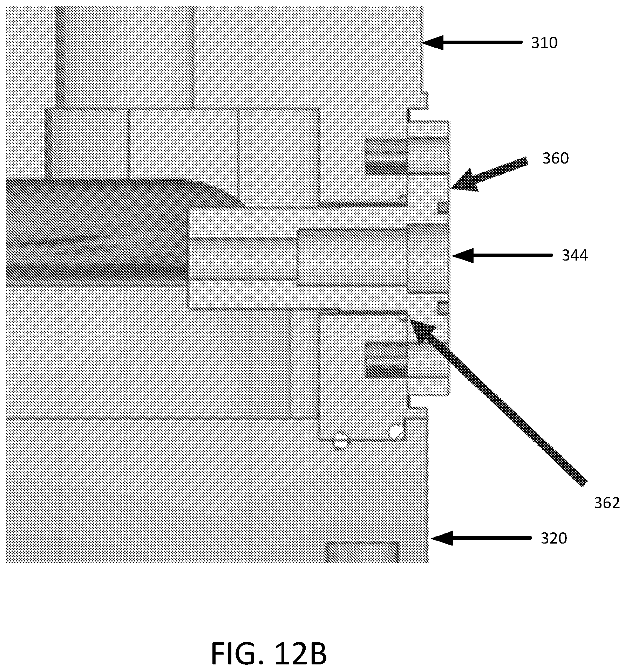

FIG. 12B schematically shows a configuration of the lower coolant level tube port 344. The port 344 includes a feedthrough 360 and a port indium wire 362. The feedthrough 360 may be tightened on the inside with a nut to compress the indium wire 362. The indium wire 362 may have a diameter of approximately 0.030 inches, although it should be understood that this dimension is merely illustrative and should not be viewed as limiting.

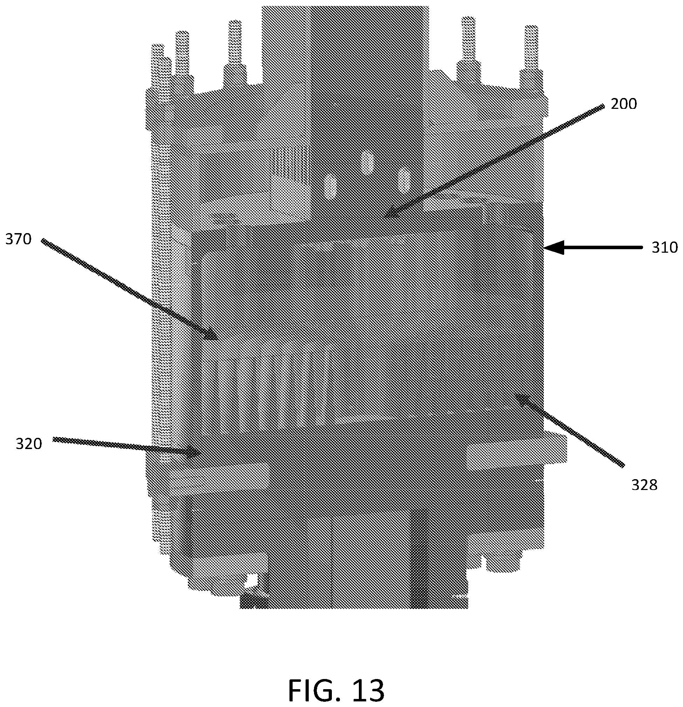

FIG. 13 schematically shows a cutaway view of an assembled heat exchanger (HEX) and boiling chamber with liquid coolant. A bottom portion of the HEX body 200 is electrically connected to the BC lid 310 using an indium joint, and compressed with internal BC lid clamps as described above (not shown). Liquid coolant (e.g. LN2) 370 is shown in the boiling chamber. The level of liquid coolant 370 may be regulated by opening or closing a coolant fill valve connected to the coolant supply line 330. The BC base 320 includes concentric BC fins 328 machined into its surface to increase the surface area of the boiling action and act as nucleation sites. The BC fins 328 themselves may be approximately 70 mm tall and 8 mm wide at the base, although it should be understood that these dimensions are merely illustrative and should not be viewed as limiting. The BC fins 328 in some embodiments are not conical, but have the shape of stacked cylinders with "steps" to break off gaseous coolant bubbles that form from the boiling action. It is appreciated, however, that fins having any shape conducive to boiling action may be used in various embodiments.

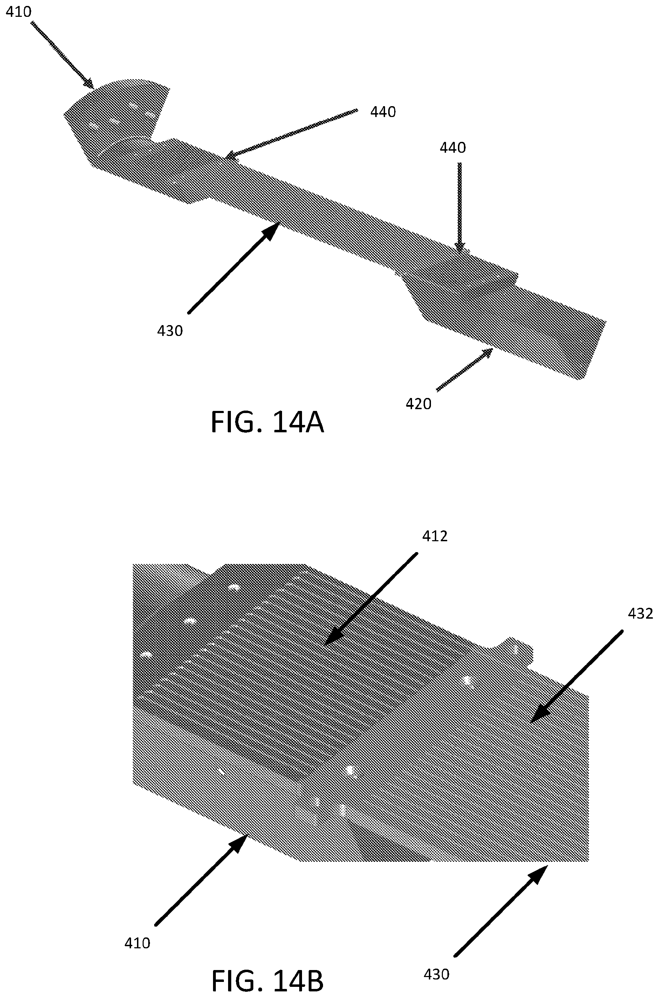

FIG. 14A schematically shows one of several electrical connectors ("petals") of a superconductor module 400 in accordance with an embodiment. The petal has an upper copper portion 410, a lower copper portion 420, and a connecting plate 430. Although copper is used for illustrative purposes, other conductive metals may be used. The upper copper portion 410 of each of the several petal mechanically couples to the underside of the boiling chamber (BC) base 320, e.g. by clamping. In accordance with the concepts, techniques, and structures disclosed herein, the electrical coupling of the upper copper portion 410 to the BC base 320 may use indium wire joints to facilitate efficient operation while preserving the ability to easily disassemble for testing, maintenance, and repair. The connecting plate 430 may be made of stainless steel that has been nickel-plated, to ensure that solder adheres to its surface. The connecting plate 430 is brazed at each end 440 to the upper copper portion 410 and the lower copper portion 420, respectively. The lower copper portion 420 connects to the superconducting portion of the powered device, e.g. a superconducting cable for conveying power to a toroidal electromagnet in a nuclear fusion reactor.

FIG. 14B shows an enlargement of the upper copper portion 410 and the connecting plate 430 near the brazed end 440 of the latter. The upper copper portion 410 includes several shallow grooves 412, and the connecting plate 430 includes several aligned shallow grooves 432. In accordance with various embodiments, high-temperature superconductor (HTS) tapes or cables are laid into these grooves 412, 432, then stabilized in place (e.g. by soldering). The HTS tapes convey current, received in the upper copper portion 410 from the BC base 320, to the lower copper portion 420 with no electrical resistance. For this purpose, the lower copper portion 420 also includes shallow grooves with inlaid HTS tape (not shown).

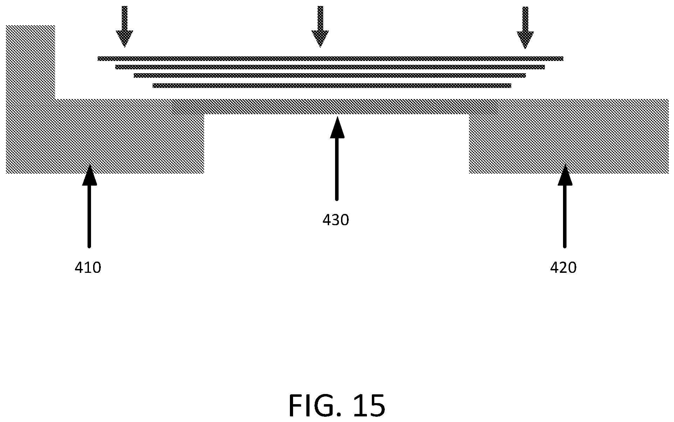

FIG. 15 shows a side view of a manner of assembling HTS tapes into a petal. Shown are the upper copper portion 410, the lower copper portion 420, and the connecting plate 430. Illustratively, four HTS tapes are placed in each groove with their respective superconducting sides facing towards the copper (i.e. "downward into" the groove). HTS at each end is "stair-stepped" as shown, which exposes the superconducting face of each tape to both copper portions. Although a stair-stepped arrangement is used for this embodiment, other stacking arrangements can be used. After laying the HTS tapes into each groove, solder is placed in the groove. Then the entire assembly is wrapped in a vacuum bag and heated, to solder all of the components together. Once soldered, current in the copper portions 410, 420 can enter the HTS tapes and travel with zero electrical resistance and very low thermal conductivity down the connecting plate 430 to exit on the other side.

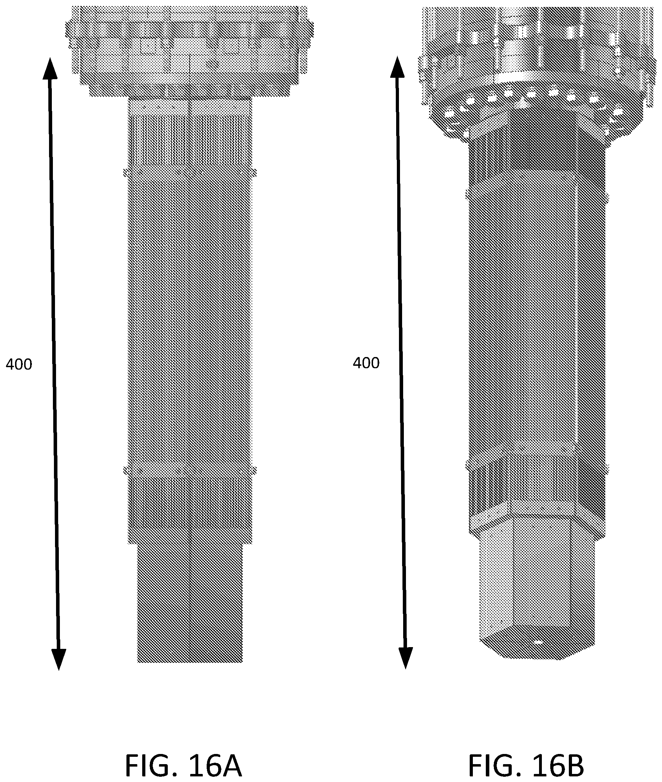

FIG. 16A is a side view of a superconductor module 400 having six petals. FIG. 16B is a bottom perspective view of the superconductor module 400 of FIG. 16A. Note that the petals may be electrically tested in liquid coolant (e.g. LN2) to confirm performance prior to their electrical connection to the underside of the BC base 320 using indium wire, and their mechanical connection using clamps. Although six petals are used for this embodiment, in principle any number could be used.

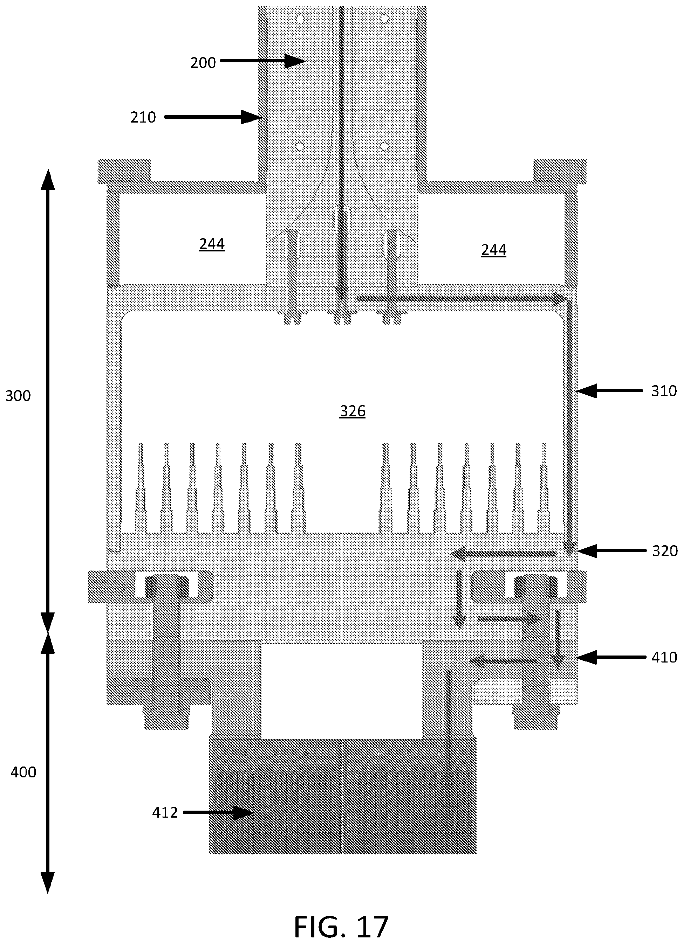

FIG. 17 schematically shows current flow through an assembled HEX 200 / BC 300 / superconductor module 400 in accordance with an embodiment. As noted above, threaded rods keep indium seals between the various components in constant compression. Bolts keep the BC base 320 mechanically coupled to the upper copper portions 410 of the superconductor module 400.

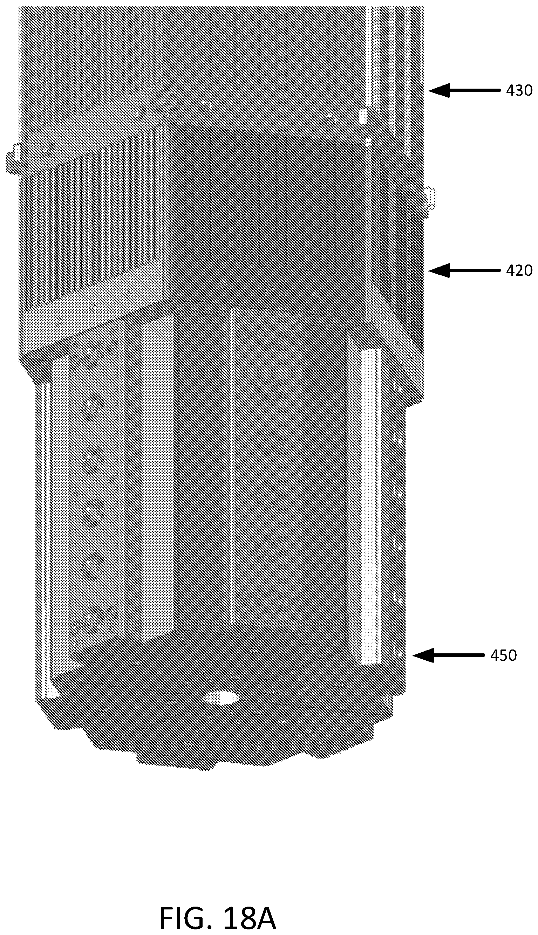

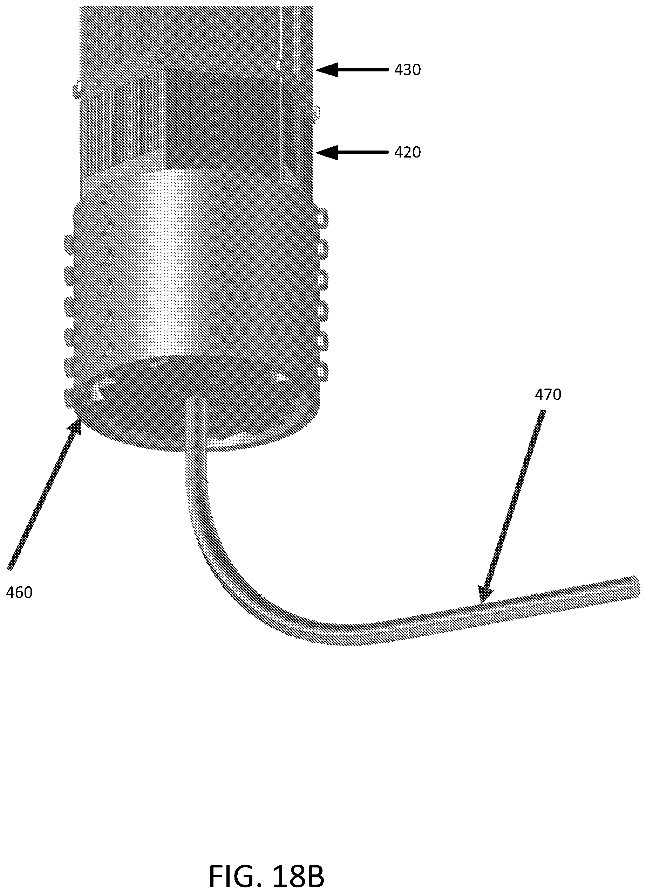

FIG. 18A schematically shows a lower portion of a superconductor module 400 having six petals. The lower copper portion 420 and connecting plate 430 for one petal are identified. Also shown is a bracket 450, whose function is discussed in connection with FIG. 18B.

FIG. 18B schematically shows the lower portion of the superconductor module 400 of FIG. 18A, with an installed clamping fixture 460 and superconducting cable 470. The clamping fixture 460 clamps onto the brackets 450 to compress indium wire used for electrically connecting the respective lower copper portions 420 onto a superconducting cable 470. The clamping fixture 460 may be bolted on as shown, or otherwise clamped to the brackets 450. The superconducting cable 470 may be silver plated and wrapped in indium wire, to facilitate ease of assembly and disassembly.

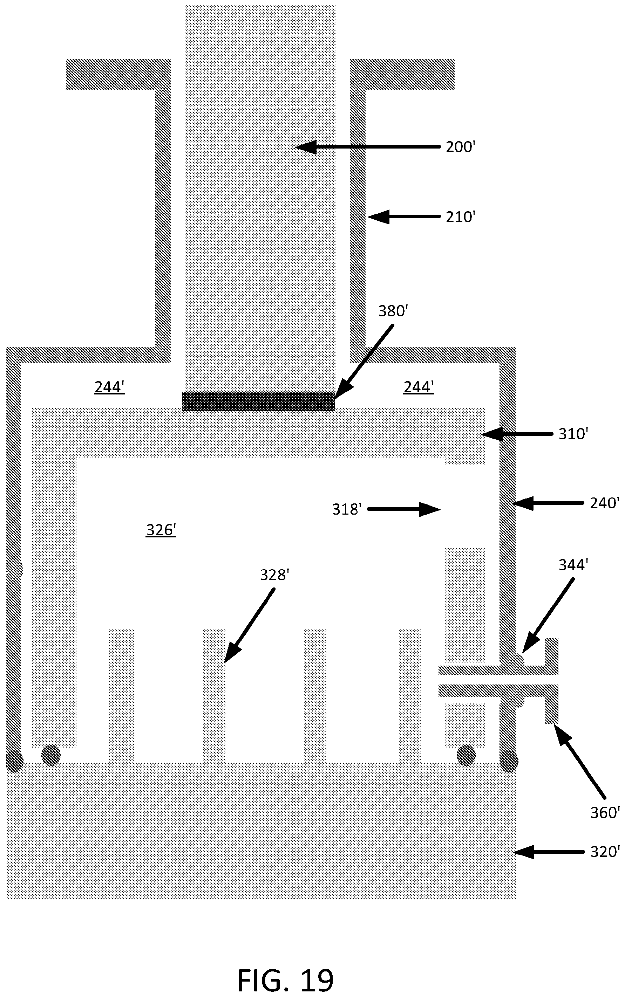

FIG. 19 schematically shows an alternate embodiment of the concepts, techniques, and structures disclosed herein, in which the vacuum lid and the boiling chamber (BC) lid are brazed to the BC base. Shown are a HEX body 200', vacuum shell 210', vacuum lid 240', vacuum lid cavity 244', BC lid 310', BC base 320', a large BC lid coolant exhaust hole 318', BC cavity 326', BC fins 328', coolant level tube port 344', and port feedthrough 360'. Also shown is an indium electrical joint 380' between the HEX body 200' and the BC lid 310'. As with embodiments described above, all mechanical joins on the vacuum shell 210' (e.g. in the corners) are welded. However, as noted above the vacuum lid 250' and the BC lid 310' are brazed to the BC base 320'. Thus, indium is not used as a vacuum seal, in case fatigue life and high voltage insulation compatibility are design concerns. However indium continues to be used as an electrical joint, in accordance with the concepts, techniques, and structures disclosed herein.

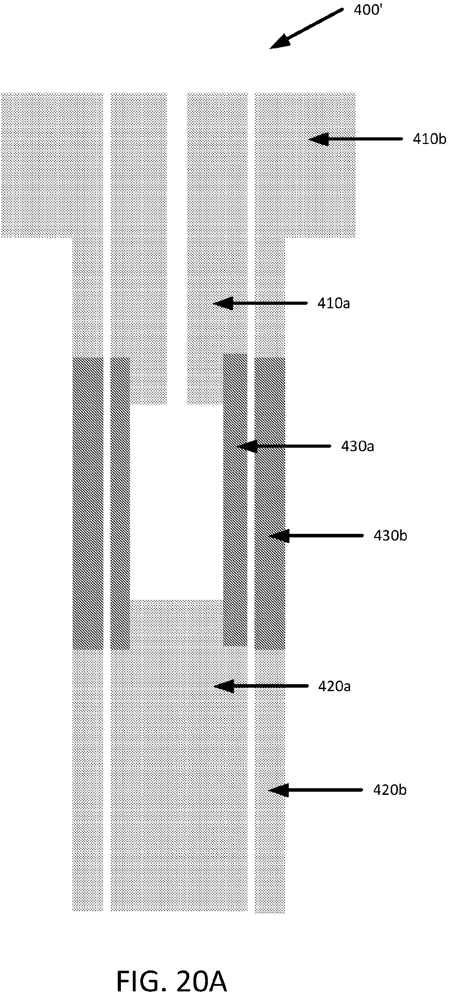

FIG. 20A schematically shows a cross-section of a "jacketed former" superconductor module 400' in accordance with an embodiment of the concepts, techniques, and structures disclosed herein. The superconductor module 400' includes an interior former having an upper copper portion 410a, a lower copper portion 420a, and a stainless steel connecting plate 430a. The superconductor module 400' also includes an exterior jacket having an upper copper portion 410b, a lower copper portion 420b, and a stainless steel connecting plate 430b. Each upper copper portion 410a, 410b may be a single piece of copper, providing full electrical connectivity around the annulus. Likewise, each lower copper portion 420a, 420b may be a single piece of copper, and each connecting plate 430a, 430b may be a single piece of stainless steel. Gaps in the superstructure may be filled with solder to produce structural and electrical stability.

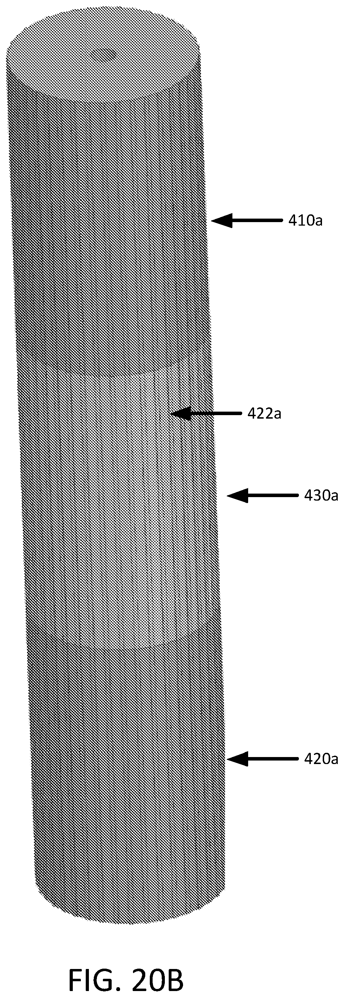

FIG. 20B schematically shows a former in accordance with the embodiment of FIG. 20A. The upper copper portion 410a, lower copper portion 420a, and stainless steel connecting plate 430a are shown. Also shown are grooves 422a, which extend from one end of the former to the other. These grooves 422a may be used in the same way as the grooves shown in FIG. 14B and 15, to provide a location in which to lay high-temperature superconductor (HTS) tapes and thereby provide zero-resistance electrical coupling between the ends of the former.

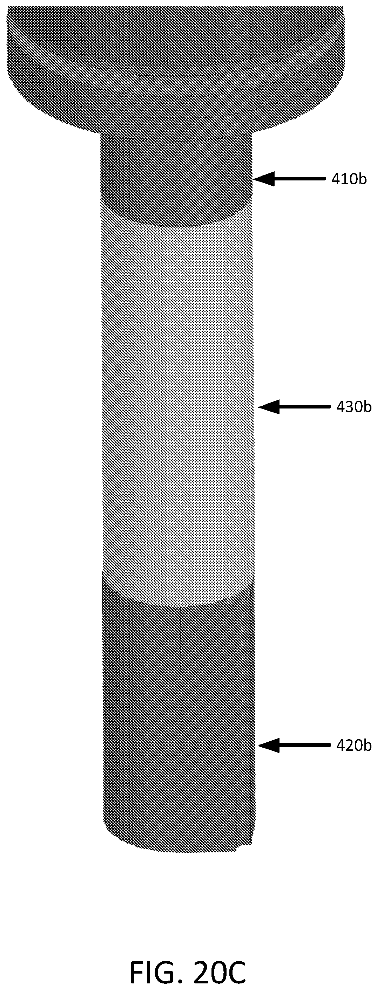

FIG. 20C schematically shows a jacket surrounding a former in accordance with the embodiment of FIGs. 20A and 20B. The upper copper portion 410b, lower copper portion 420b, and stainless steel connecting plate 430c are shown. Advantageously, assembly of the jacketed former may be accomplished by simply sliding the jacket over the top of the former, then soldering as described above.

The operation and use of various embodiments are now described.

In general, a current lead in accordance with the concepts, techniques, and structures disclosed should have the following characteristics. The current lead should carry a desired current with minimal heat load to the cryogenic circuit. The current lead should maintain thermal stability, as overheating can cause damage, and overcooling can cause condensation/freezing which damages electronics. The current lead should have sufficient parameter margin within the superconductor module such that it always remains superconducting. Additional useful features include simplicity of operation and control, build quickness with high confidence in the manufacturing process, and ability to test modular components to the full operating current.

In order to carry the current, most or all conductive sections of the current lead are joined with indium wire, as described above. This ensures near-complete coverage of the interfacing area with high electric- and thermal-conductivity indium. In turn, this results in low resistance connections between sections which helps ensure thermal stability. Indium may also be used to create vacuum seals and as an alternative to brazing. This method is high confidence, easily repairable, and rapid to iterate upon, which results in manufacturing success.

The boiling chamber (BC), with its very high surface area for boiling LN2, serves to keep the upper, warm end of the superconductor module thermally stable and ensures it remains superconducting at all times. Operation and control may be done in this case by an electrically controlled proportional-integral-derivative (PID) loop, where the fill valve controls to a set point in LN2 level. The lead is then self-regulating and can operate at any current with that level, and will be filled in proportion to how much vapor is generated in the BC. The heat exchanger (HEX), which has GN2 flowing within it, has its length and area tailored such that it also does not have more ohmic heating than there is coolant available. The HEX section is also designed to have low pressure drop in the flowing GN2 to keep boiling pressure and temperature in the BC as low as possible.

The superconductor module may be created in sections or wedges, called petals as shown in FIGs. 14A, 14B, 15, 16A, and 16B and described above. Each petal only has to carry a fraction of the total current because the petals are in electrical parallel, and this makes testing each petal much simpler than testing the entire assembly at once. It also reduces risk to the superconductor module in that if one petal performs poorly, it may be replaced by itself, without replacing the rest of the superconductor module. The number of petals may be determined by calculating magnetic field strength along the superconductor module, calculating the resultant critical current of each piece of high-temperature superconductor (HTS) tape, then determining total required amount of HTS. In general, more petals makes a more uniform (and parallel to tape face) field which reduces HTS tape usage and cost, while fewer petals in a design requires more HTS. Thus, it is appreciated that the number of petals need not be exactly six as shown in the Figures, but is a function of a number of situation-specific design parameters.

Alternately, as shown in FIGs. 20A and 20B above, the superconductor module may be created as a single former surrounded by a jacket.

The biggest risks to the current lead performance include manufacturing risks from brazing, which is essentially a non-reversible process; overheating due to high resistance interfaces or loss of superconductivity (quenching) in the superconductor module 400 warm end; and running out of coolant within the BC, which causes overheating.

Additional embodiments and variations on the above embodiments are now described.

The room-temperature terminal portion (RTTP) of the heat exchanger (HEX) is temperature controlled through two water heat exchanger loops running over the copper. This loop is connected to a system that can heat or cool the water to a specific set point as measured on the RTTP. This ensures that over a range of operating scenarios, the leads will not condense or freeze water at the current lead and a cryostat in which they are mounted, which can cause problems with soft O-ring seals and instrumentation. The temperature of the top end naturally varies with current, because at zero current there is very little heating so it will tend to cool down, while at full operating current a properly designed lead should need close to zero heating or cooling.

Alternatively, some designs may use only a heater at the top end in order to keep the current lead from cooling too much at zero current. However, in such designs if the RTTP overheats when experiencing operational current, there is no method to cool it down. Humidity may be removed from the surrounding room, or a nitrogen atmosphere created around the RTTP to prevent condensation. Both of these approaches require more careful monitoring than the water-cooled passages used here.

Soft indium joints are used to create both vacuum seals and electrical connections and thermal connection between conductive metal sections. These seals are repairable and when designed properly have high likelihood of successful operation. However, there are other soft metals, such as lead, that could be used to make connections between sections. Standard polymer O-rings cannot be used at these cryogenic temperatures, so the standard approach is to braze. This carries the risk of having small, irreparable leaks or imperfections within the mating surfaces.

The boiling chamber is designed with very large surface area to keep its temperature as close to that of boiling LN2 as possible. This ensures that the warm end of the superconductor module remains above the superconductor's critical temperature. For example the upper temperature of the superconductor module may only vary by about 1 K across all operating states, and there may be a built-in margin of 2-3 K on the upper temperature of the superconductor module before loss of superconductivity occurs. Physical configurations other than those shown in the Figures are possible to achieve high surface area. Skipping LN2 altogether and using only GN2 would not be very effective from a thermal perspective due to a relatively small sensible heat, and riskier to implement. Some previous current leads use only helium which has a temperature set by the cryocooling system. Due to the properties of helium, these systems typically only use gaseous helium

Coolant level within the boiling chamber is measured by a parallel level tube off to the side. Level within this tube is measured with a capacitive style sensor. This is done firstly for electrical isolation so that the level sensor could be grounded to the cryostat, whereas the current lead shares ground through its power supply. Secondly, by placing the level sensor off to the side, the LN2 within the tube should see minimal boiling and make the level reading more consistent. In alternative embodiments, the level stick may be placed directly within the boiling chamber, but the vigorous boiling could cause unwanted oscillation in the measurement and resulting fill valve control.

This system could be considered an 'active' system because it is controlled. If many current leads are designed to operate in a facility, it is possible to 'passively' feed the LN2 into each lead. There would simply be one large supply of LN2, where level and fill are actively controlled, and that level would be shared with all of the leads simply by connecting them together to a common supply reservoir. Other methods of level measurement are available such as floats and optical systems.

The current lead is designed vertically so that exhaust GN2 naturally rises as it warms to exit the leads. However, the CL could be built horizontally as well, and the boiling action would push GN2 out towards the HEX in a similar manner, or a vacuum pump at the exhaust can support gas circulation.

The described current lead has the ability to lower the pressure inside the boiling chamber to lower the boiling temperature of the LN2. This feature may be used as a backup if, for some reason, the top of the superconductor module has a higher temperature than expected and cannot be properly controlled by atmospheric boiling of LN2 at its maximum of 77.3 K. By pumping out the chamber to ~130 Torr, the boiling temperature of LN2 can be decreased to about 65 K which buys significant temperature margin for the upper end of the superconductor module.

It is to be understood that the phraseology and terminology employed herein are for the purpose of description and should not be regarded as limiting. As such, those skilled in the art will appreciate that the conception, upon which this disclosure is based, may readily be utilized as a basis for the designing of other structures, methods, and systems for carrying out the several purposes of the disclosed subject matter.

In the foregoing detailed description, various features of embodiments are grouped together in one or more individual embodiments for the purpose of streamlining the disclosure. This method of disclosure is not to be interpreted as reflecting an intention that the claims require more features than are expressly recited therein. Rather, inventive aspects may lie in less than all features of each disclosed embodiment.

As used herein, "including" means including without limitation. As used herein, the terms "a" and "an", when modifying a noun, do not imply that only one of the noun exists. As used herein, unless the context clearly indicates otherwise, "or" means and/or. For example, A or B is true if A is true, or B is true, or both A and B are true. As used herein, "for example", "for instance", "e.g.", and "such as" refer to non-limiting examples that are not exclusive examples. The word "consists" (and variants thereof) are to be give the same meaning as the word "comprises" or "includes" (or variants thereof).

It is noted that various connections and positional relationships (e.g., over, below, adjacent, etc.) are set forth between elements in the following description and in the drawings. These connections and/or positional relationships, unless specified otherwise, can be direct or indirect, and the described concepts, systems, devices, structures and techniques are not intended to be limiting in this respect. Accordingly, a coupling of entities can refer to either a direct or an indirect coupling, and a positional relationship between entities can be a direct or indirect positional relationship.

As an example of an indirect positional relationship, references in the present description to forming layer "A" over layer "B" include situations in which one or more intermediate layers (e.g., layer "C") is between layer "A" and layer "B" as long as the relevant characteristics and functionalities of layer "A" and layer "B" are not substantially changed by the intermediate layer(s).The following definitions and abbreviations are to be used for the interpretation of the specification. As used herein, the terms "comprises," "comprising, "includes," "including," "has," "having," "contains" or "containing," or any other variation thereof, are intended to cover a non-exclusive inclusion. For example, a composition, a mixture, process, method, article, or apparatus that comprises a list of elements is not necessarily limited to only those elements but can include other elements not expressly listed or inherent to such composition, mixture, process, method, article, or apparatus.

Additionally, the term "exemplary" is used herein to mean "serving as an example, instance, or illustration. Any embodiment or design described herein as "exemplary" is not necessarily to be construed as preferred or advantageous over other embodiments or designs. The terms "one or more" and "one or more" are understood to include any integer number greater than or equal to one, i.e. one, two, three, four, etc. The terms "a plurality" are understood to include any integer number greater than or equal to two, i.e. two, three, four, five, etc. The term "connection" can include an indirect "connection" and a direct "connection."

References in the specification to "one embodiment, "an embodiment," "an example embodiment," etc., indicate that the embodiment described can include a particular feature, structure, or characteristic, but every embodiment can include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

For purposes of the description hereinafter, the terms "upper," "lower," "right," "left," "vertical," "horizontal, "top," "bottom," and derivatives thereof shall relate to the described structures and methods, as oriented in the drawing figures. The terms "overlying," "atop," "on top, "positioned on" or "positioned atop" mean that a first element, such as a first structure, is present on a second element, such as a second structure, where intervening elements such as an interface structure can be present between the first element and the second element. The term "direct contact" means that a first element, such as a first structure, and a second element, such as a second structure, are connected without any intermediary elements.

Use of ordinal terms such as "first," "second," "third," etc., in the specification to modify an element does not by itself connote any priority, precedence, or order of one element over another or the temporal order in which acts of a method are performed, but are used merely as labels to distinguish one element having a certain name from another element having a same name (but for use of the ordinal term) to distinguish the elements.

The terms "approximately" and "about" may be used to mean within ±20% of a target value in some embodiments, within ±10% of a target value in some embodiments, within ±5% of a target value in some embodiments, and yet within ±2% of a target value in some embodiments. The terms "approximately" and "about" may include the target value. The term "substantially equal" may be used to refer to values that are within ±20% of one another in some embodiments, within ±10% of one another in some embodiments, within ±5% of one another in some embodiments, and yet within ±2% of one another in some embodiments.

The term "substantially" may be used to refer to values that are within ±20% of a comparative measure in some embodiments, within ±10% in some embodiments, within ±5% in some embodiments, and yet within ±2% in some embodiments. For example, a first direction that is "substantially" perpendicular to a second direction may refer to a first direction that is within ±20% of making a 90° angle with the second direction in some embodiments, within ±10% of making a 90° angle with the second direction in some embodiments, within ±5% of making a 90° angle with the second direction in some embodiments, and yet within ±2% of making a 90° angle with the second direction in some embodiments.

## Claims

1. A current lead (10) comprising:
a heat exchanger comprising at least one electrically conductive structure (102) having a room-temperature portion (100) for electrically connecting to one or more room-temperature power supply lines (160), and having one or more coolant exhaust ports (130);
a boiling chamber (300) comprising one or more coolant intake ports (242) and at least one electrically conductive structure (310, 320; 310'-320') electrically connected to the at least one electrically conductive structure of the heat exchanger, wherein an electrical connection between the at least one electrically conductive structure of the boiling chamber and the at least one electrically conductive structure of the heat exchanger comprises a mechanically compressed indium electrical joint (312, 380') galvanically connected to the at least one electrically conductive structure of the boiling chamber and to the at least one electrically conductive structure of the heat exchanger;
a plurality of bolts attaching the boiling chamber to the heat exchanger and providing mechanical compression of the indium electrical joint; and
a superconductor module (400) comprising at least one electrically conductive structure (410) electrically connected to the at least one electrically conductive structure of the boiling chamber, wherein the at least one electrically conductive structure of the superconductor module comprises high temperature superconductor, HTS.

2. The current lead of claim 1, wherein the at least one electrically conductive structure of the boiling chamber comprises copper, and the at least one electrically conductive structure of the heat exchanger comprises copper.

3. The current lead of claim 1, wherein the at least one electrically conductive structure of the heat exchanger includes a copper element (102) that extends into the room-temperature portion and is galvanically connected to the one or more room-temperature power supply lines.

4. The current lead of claim 1, wherein the superconductor module comprises a metal tube or plate (430) that includes one or more channels (412, 432) in walls of the tube or plate, and where the HTS is arranged within the one or more channels.

5. The current lead of claim 1, wherein the heat exchanger comprises a vacuum shell (210) arranged around the at least one electrically conductive structure of the heat exchanger.

6. The current lead of claim 1, wherein the at least one electrically conductive structure of the heat exchanger comprises a chamber coupled to the one or more coolant intake ports.

7. The current lead of claim 6, wherein the boiling chamber comprises a plurality of fins (328).

8. The current lead of claim 6, wherein the at least one electrically conductive structure of the heat exchanger comprises one or more gas channels (220), and wherein the chamber of the heat exchanger is coupled to the one or more gas channels.

9. A system comprising the current lead of claim 1 and a source of liquid nitrogen coupled to the one or more coolant intake ports.

## Patentansprüche

1. Eine Stromzuleitung (10), die Folgendes beinhaltet:
einen Wärmeaustauscher, der mindestens eine elektrisch leitfähige Struktur (102) beinhaltet, die einen Raumtemperaturabschnitt (100) zum elektrischen Verbinden mit einer oder mehreren Raumtemperatur-Energieversorgungsleitungen (160) aufweist und einen oder mehrere Kühlmittelaustrittsanschlüsse (130) aufweist;
eine Siedekammer (300), die einen oder mehrere Kühlmittelaufnahmeanschlüsse (242) und mindestens eine elektrisch leitfähige Struktur (310, 320; 310'-320'), die elektrisch mit der mindestens einen elektrisch leitfähigen Struktur des Wärmeaustauschers verbunden ist, beinhaltet, wobei eine elektrische Verbindung zwischen der mindestens einen elektrisch leitfähigen Struktur der Siedekammer und der mindestens einen elektrisch leitfähigen Struktur des Wärmeaustauschers eine mechanisch komprimierte elektrische Indiumfuge (312, 380') beinhaltet, die galvanisch mit der mindestens einen elektrisch leitfähigen Struktur der Siedekammer und mit der mindestens einen elektrisch leitfähigen Struktur des Wärmeaustauschers verbunden ist;
eine Vielzahl von Schrauben, die die Siedekammer an dem Wärmeaustauscher befestigen und mechanische Kompression der elektrischen Indiumfuge bereitstellen; und
ein Supraleitermodul (400), das mindestens eine elektrisch leitfähige Struktur (410) beinhaltet, die elektrisch mit der mindestens einen elektrisch leitfähigen Struktur der Siedekammer verbunden ist, wobei die mindestens eine elektrisch leitfähige Struktur des Supraleitermoduls einen Hochtemperatursupraleiter, HTS, beinhaltet.

2. Stromzuleitung gemäß Anspruch 1, wobei die mindestens eine elektrisch leitfähige Struktur der Siedekammer Kupfer beinhaltet und die mindestens eine elektrisch leitfähige Struktur des Wärmeaustauschers Kupfer beinhaltet.

3. Stromzuleitung gemäß Anspruch 1, wobei die mindestens eine elektrisch leitfähige Struktur des Wärmeaustauschers ein Kupferelement (102) umfasst, das sich in den Raumtemperaturabschnitt erstreckt und galvanisch mit der einen oder den mehreren Raumtemperatur-Energieversorgungsleitungen verbunden ist.

4. Stromzuleitung gemäß Anspruch 1, wobei das Supraleitermodul ein Metallrohr oder eine Metallplatte (430) beinhaltet, das/die einen oder mehrere Kanäle (412, 432) in Wänden des Rohrs oder der Platte umfasst, und wobei der HTS innerhalb des einen oder der mehreren Kanäle angeordnet ist.

5. Stromzuleitung gemäß Anspruch 1, wobei der Wärmeaustauscher eine Vakuumummantelung (210) beinhaltet, die um die mindestens eine elektrisch leitfähige Struktur des Wärmeaustauschers herum angeordnet ist.

6. Stromzuleitung gemäß Anspruch 1, wobei die mindestens eine elektrisch leitfähige Struktur des Wärmeaustauschers eine Kammer beinhaltet, die mit dem einen oder den mehreren Kühlmittelaufnahmeanschlüssen gekoppelt ist.

7. Stromzuleitung gemäß Anspruch 6, wobei die Siedekammer eine Vielzahl von Rippen (328) beinhaltet.

8. Stromzuleitung gemäß Anspruch 6, wobei die mindestens eine elektrisch leitfähige Struktur des Wärmeaustauschers einen oder mehrere Gaskanäle (220) beinhaltet und wobei die Kammer des Wärmeaustauschers mit der einen oder den mehreren Gaskanälen gekoppelt ist.

9. Ein System, das die Stromzuleitung gemäß Anspruch 1 und eine Quelle flüssigen Stickstoffs, die mit dem einen oder den mehreren Kühlmittelaufnahmeanschlüssen gekoppelt ist, beinhaltet.

## Revendications

1. Un conducteur de courant (10) comprenant :
un échangeur de chaleur comprenant au moins une structure électriquement conductrice (102) ayant une partie à température ambiante (100) pour se connecter électriquement à une ou plusieurs lignes d'alimentation électrique à température ambiante (160), et ayant un ou plusieurs orifices d'échappement de fluide de refroidissement (130) ;
une chambre d'ébullition (300) comprenant un ou plusieurs orifices d'admission de fluide de refroidissement (242) et au moins une structure électriquement conductrice (310, 320 ; 310'-320') électriquement connectée à l'au moins une structure électriquement conductrice de l'échangeur de chaleur, une connexion électrique entre l'au moins une structure électriquement conductrice de la chambre d'ébullition et l'au moins une structure électriquement conductrice de l'échangeur de chaleur comprenant un joint électrique en indium comprimé mécaniquement (312, 380') connecté galvaniquement à l'au moins une structure électriquement conductrice de la chambre d'ébullition et à l'au moins une structure électriquement conductrice de l'échangeur de chaleur ;
une pluralité de boulons fixant la chambre d'ébullition à l'échangeur de chaleur et fournissant une compression mécanique du joint électrique en indium ; et
un module supraconducteur (400) comprenant au moins une structure électriquement conductrice (410) électriquement connectée à l'au moins une structure électriquement conductrice de la chambre d'ébullition, l'au moins une structure électriquement conductrice du module supraconducteur comprenant un supraconducteur à haute température, HTS.

2. Le conducteur de courant de la revendication 1, dans lequel l'au moins une structure électriquement conductrice de la chambre d'ébullition comprend du cuivre, et l'au moins une structure électriquement conductrice de l'échangeur de chaleur comprend du cuivre.

3. Le conducteur de courant de la revendication 1, dans lequel l'au moins une structure électriquement conductrice de l'échangeur de chaleur comporte un élément en cuivre (102) qui s'étend dans la partie à température ambiante et est connecté galvaniquement aux une ou plusieurs lignes d'alimentation électrique à température ambiante.

4. Le conducteur de courant de la revendication 1, dans lequel le module supraconducteur comprend un tube ou une plaque en métal (430) qui comporte un ou plusieurs canaux (412, 432) dans des parois du tube ou de la plaque, et où le HTS est disposé à l'intérieur des un ou plusieurs canaux.

5. Le conducteur de courant de la revendication 1, dans lequel l'échangeur de chaleur comprend une enveloppe sous vide (210) disposée autour de l'au moins une structure électriquement conductrice de l'échangeur de chaleur.

6. Le conducteur de courant de la revendication 1, dans lequel l'au moins une structure électriquement conductrice de l'échangeur de chaleur comprend une chambre couplée aux un ou plusieurs orifices d'admission de fluide de refroidissement.

7. Le conducteur de courant de la revendication 6, dans lequel la chambre d'ébullition comprend une pluralité d'ailettes (328).

8. Le conducteur de courant de la revendication 6, dans lequel l'au moins une structure électriquement conductrice de l'échangeur de chaleur comprend un ou plusieurs canaux de gaz (220), et dans lequel la chambre de l'échangeur de chaleur est couplée aux un ou plusieurs canaux de gaz.

9. Un système comprenant le conducteur de courant de la revendication 1 et une source d'azote liquide couplée aux un ou plusieurs orifices d'admission de fluide de refroidissement.
